# EUROPÄISCHE PATENTANMELDUNG

(11) **EP 2 133 994 A1**
(43) Veröffentlichungstag der Anmeldung: **16.12.2009**
(21) Anmeldenummer: 08010693.3
(22) Anmeldetag: 12.06.2008
(51) Int. Cl.: H03K 3/537

(54) **Stossspannungsgeneratormodul und Stossspannungsgenerator**

(71) Anmelder: ABB Technology AG, 8050 Zürich (CH)
(72) Erfinder: Steiger, Matthias, 06779 Schierau (DE)
(74) Vertreter: Partner, Lothar

(57) **Zusammenfassung**

Die Erfindung betrifft Stossspannungsgeneratormodul mit wenigstens zwei rohrähnlichen Isolatoren (32, 34, 36), von denen wenigstens einer jeweils einen sich wenigstens über einen Teil dessen gesamter Länge erstreckenden inneren Hohlraum aufweist. Zwischen wenigstens zwei der Isolatoren (32, 34, 36) ist wenigstens eine elektrische Komponente (C_{S}, R_{L1}, R_{L2}, R_{D}, F_{X}) angeordnet und mechanisch mit diesen (32, 34, 36) verbunden. Im Hohlraum wenigstens eines der Isolatoren (32, 34, 36) ist wenigstens eine elektrische Innenkomponente (C_{T}) angeordnet. Die Erfindung betrifft weiterhin einen Stossspannungsgenerator mit erfindungsgemäßen Stossspannungsgeneratormodulen.

## Beschreibung

Die Erfindung betrifft ein Stossspannungsgeneratormodul mit wenigstens zwei rohrähnlichen Isolatoren, von denen wenigstens einer jeweils einen sich wenigstens über einen Teil dessen gesamter Länge erstreckenden inneren Hohlraum aufweist, wobei zwischen wenigstens zwei der Isolatoren wenigstens eine elektrische Komponente angeordnet und mechanisch mit diesen verbunden ist. Die Erfindung betrifft weiterhin einen Stossspannungsgenerator mit Stossspannungsgeneratormodulen.

Es ist allgemein bekannt, dass zur Prüfung von Hochspannungskomponenten, insbesondere von Leistungstransformatoren, Stossspannungsgeneratoren verwendet werden.

Ein Stossspannungsgenerator weist eine Vielzahl von Kondensatoren auf, welche zur Erzeugung eines Hochspannungsimpulses zunächst in elektrischer Parallelschaltung geladen werden und anschließend in elektrischer Reihenschaltung entladen werden. Durch die Reihenschaltung sind entsprechend höhere Spannungen realisierbar. Die Ausführungsform eines Stossspannungsgenerators ist gemäß dem allgemeinen Stand der Technik zumeist in einer turmähnlichen Struktur, in welcher die verwendeten Komponenten Kondensator, Widerstand, Funkenstrecke sowie Isolatoren in einer Gitterstruktur zusammengefügt sind. Die Isolatoren sind auch als Rohre aus einem Isolationsmaterial, beispielsweise GFK, ausführbar, wobei die Isolatoren vorzugsweise längs der turmähnlichen Struktur hintereinander in Form von mehreren sich über die gesamte Länge der Struktur erstreckenden Stützsäulen angeordnet sind und die elektrischen Komponenten quer dazu.

Für den Betrieb eines Stossspannungsgenerators in einer Prüfanordnung sind üblicherweise weitere Funktionalitäten erforderlich, insbesondere die eines Spannungsteilers und die einer Funkenabschnittsstrecke bzw. eines Überspannungsableiters.

Stossspannungsgeneratoren produzieren Spannungsimpulse von bis zu einigen MV. Im Rahmen einer Stossspannungsprüfung eines Prüflings ist der zeitliche Verlauf des Spannungsimpulses, welcher im zeitlichen Bereich von maximal einigen 100µm liegt, messtechnisch zu erfassen. Hierfür ist ein Spannungsteiler erforderlich, welcher mit dem Ausgang des Stossspannungsgenerators verbunden ist und welcher die anliegende Spannung in eine hierzu proportionale geringere und somit einfacher messbare Spannung wandelt.

Derartige Spannungsteiler sind für die Messung von Hochspannungsimpulsen z.B. kapazitiv ausgeführt, d.h. es sind mehrere Kondensatoren zwischen dem Ausgang des Stossspannungsgenerators und Erdpotential in elektrischer Reihenschaltung angeordnet; wobei die Spannung vorzugsweise an den beiden Anschlüssen des mit Erdpotenzial verbundenen Kondensators gemessen wird. Es sind aber auch rein resistive Spannungsteiler oder auch Spannungsteiler in einer Anordnung mit Kondensatoren und Widerständen möglich.

Weiterhin ist es für den Betrieb eines Stossspannungsgenerators in einer Prüfanordnung gegebenenfalls erforderlich, den erzeugten Spannungsimpuls ab Erreichen eines bestimmten Spannungswertes abzuschneiden, d.h. elektrisch kurzzuschließen. Auf diese Weise wird der zeitliche Verlauf des Spannungsimpulses beeinflusst. Dies wird üblicherweise mit einer Funkenabschnittsstrecke beziehungsweise einem Überspannungsleiter realisiert. Eine diesbezügliche Anordnung weist wenigstens eine Funkenstrecke, welche bei Erreichen einer bestimmten Spannung zündet, sowie dazu in elektrischer Reihenschaltung wenigstens einen Widerstand auf. Eine derartige Funkenabschnittsstrecke kann auch als Anordnung von mehreren Funkenstrecken und Widerständen ausgeführt werden.

Sowohl Spannungsteiler als auch Funkenabschnittsstrecken sind längliche Anordnungen, welche vorzugsweise parallel zu der Längsachse des senkrecht stehenden Stossspannungsgenerators positioniert sind und welche eine ähnliche Höhe wie der Stossspannungsgenerator, beispielsweise 10m, aufweisen.

Nachteilig hierbei ist insbesondere, dass Spannungsteiler und Funkenabschnittsstrecke oder auch weitere Anordnungen von elektrischen Komponenten, wie beispielsweise Kondensatoren, Widerständen und Funkenstrecken, welche mit dem Stossspannungsgenerator zusammenwirken, einen zusätzlichen Platz innerhalb der Prüfanordnung erfordern, insbesondere auch, um einen elektrischen lsolationsabstand untereinander sicherzustellen.

Ausgehend von diesem Stand der Technik ist es Aufgabe der Erfindung, eine platzsparende Anordnung von weiteren elektrischen Komponenten an einem Stossspannungsgenerator anzugeben.

Diese Aufgabe wird erfindungsgemäß gelöst durch ein Stossspannungsgeneratormodul mit den im Anspruch 1 angegebenen Merkmalen.

Demgemäß kennzeichnet sich das Stossspannungsgeneratormodul der eingangs genannten Art dadurch, dass wenigstens eine elektrische Innenkomponente im Hohlraum wenigstens eines der Isolatoren angeordnet ist.

Die Dicke der Wandung des Isolators ist hierbei so auszuführen, dass im Betrieb des Stossspannungsgenerators kein elektrischer Durchschlag zu einer in seinem Inneren angeordneten Komponente erfolgen kann.

Die Integration einer elektrischen Komponente als Innenkomponente in den inneren Hohlraum wenigstens eines der Isolatoren ermöglicht somit eine isolationstechnisch sichere und zudem platzsparende Anordnung innerhalb eines Stossspannungsgeneratormoduls.

In einer bevorzugten Ausführungsform des erfindungsgemäßen Stossspannungsgeneratormoduls sind die wenigstens zwei Isolatoren räumlich parallel zueinander angeordnet.

Durch diese parallele Anordnung lassen sich mehrere, vorzugsweise gleichartige, Stossspannungsgeneratormodule, besonders einfach übereinander anordnen.

In einer weiteren Ausgestaltung des Stossspannungsgeneratormoduls sind die wenigstens eine elektrische Komponente und die wenigstens eine elektrische Innenkomponente jeweils ein Kondensator, ein Widerstand, eine Induktivität oder eine Funkenstrecke. Dies sind die wesentlichen elektrischen Komponenten, welche üblicherweise für einen Stossspannungsgenerator, einen Spannungsteiler oder für eine Funkenabschnittsstrecke verwendet werden.

Vorzugsweise weist zumindest eine der genannten elektrischen Komponenten eine Nennspannung von wenigstens 20kV auf, welche für die Verwendung innerhalb einer Prüfanordnung mit Stossspannungsgenerator besonders geeignet ist, weil so die Anzahl der in Reihe zu schaltenden Komponenten mit steigender Nennspannung der Einzelkomponenten vorteilhaft reduzierbar ist.

Die erfindungsgemäße Aufgabe wird auch gelöst durch einen Stossspannungsgenerator mit wenigstens einem erfindungsgemäßen Stossspannungsgeneratormodul.

Das erfindungsgemäße wenigstens eine Stossspannungsgeneratormodul ist mit weiteren elektrischen Komponenten beziehungsweise weiteren erfindungsgemäßen Stossspannungsgeneratormodulen derart elektrisch zu verschalten, dass sich die Funktionalität eines Stossspannungsgenerators ergibt. Vorzugsweise sind zumindest abschnittsweise gleiche Stossspannungsgeneratormodule übereinander anzuordnen, wobei gegebenenfalls auch weitere Isolatoren zu verwenden sind.

Durch die Verwendung eines derartigen Stossspannungsgeneratormoduls sind die Platzvorteile, welche sich aus der Anordnung von wenigstens einer elektrischen Innenkomponente innerhalb des Hohlraums wenigstens eines Isolators des Moduls ergeben, in vorteilhafter Weise auch auf einen Stossspannungsgenerator übertragbar.

In einer besonders bevorzugten Ausführungsform des erfindungsgemäßen Stossspannungsgenerators wirkt die im Hohlraum des wenigstens einen Isolators des wenigstens einen Stossspannungsgeneratormoduls angeordnete elektrische Innenkomponente mit wenigstens einer weiteren elektrischen Komponente elektrisch zusammen. Somit lassen sich Funktionalitäten weiterer elektrischer Anordnungen, welche vorzugsweise elektrisch mit dem Stossspannungsgenerator in einer Prüfanordnung verschaltet sind, unter Einbeziehung einer platzsparend angeordneten Innenkomponente realisieren.

Besonders bevorzugt ist hierbei eine Variante des erfindungsgemäßen Stossspannungsgenerators, bei welcher die wenigstens eine weitere elektrische Komponente eine elektrische Innenkomponente ist, welche im Hohlraum eines Isolators eines weiteren Stossspannungsgeneratormoduls des Stossspannungsgenerators angeordnet ist.

Bei-Anordnung mehrerer erfindungsgemäßer vorzugsweise gleicher oder zumindest ähnlicher Stossspannungsgeneratormodule übereinander ergeben sich nämlich vorzugsweise Säulen von entlang einer jeweiligen Linie angeordneten Isolatoren. Eine Verschaltung einer elektrischen Innenkomponente mit weiteren jeweils oberhalb oder unterhalb des betreffenden Isolators in weiteren Isolatoren angeordneten Innenkomponenten ist besonders vorteilhaft, weil sich insbesondere deren Reihenschaltung sehr einfach realisieren lässt, ohne dass ein Anschluss oder eine elektrische Verbindung einer Innenkomponente in einem isolationstechnisch ungünstigen Bereich außerhalb eines Isolators geführt ist.

In einer weiteren Variante des erfindungsgemäßen Stossspannungsgenerators bilden die zusammenwirkenden elektrischen Komponenten einen Spannungsteiler. Dessen elektrische Komponenten sind vorzugsweise innerhalb mehrerer übereinander befindlicher Isolatoren des Stossspannungsgenerators anzuordnen.

Ein derartiger Spannungsteiler ist entweder rein kapazitiv, rein resistiv oder weist auch eine gemeinsame Anordnung von Kondensatoren und Widerständen auf.

In einer weiteren Ausgestaltung des erfindungsgemäßen Stossspannungsgenerators ist der Spannungsteiler mit dem Ausgang des Stossspannungsgenerators verbunden, vorzugsweise in deren jeweiligen oberen Bereich, um so eine für die Isolation günstige Spannungsaufteilung zu realisieren.

Der Platzbedarf für einen mit dem Stossspannungsgenerator zusammenwirkenden Spannungsteiler ist dadurch vorteilhaft reduziert.

In einer weiteren Variante des erfindungsgemäßen Stossspannungsgenerators bilden die zusammenwirkenden elektrischen Komponenten einen Überspannungsableiter beziehungsweise eine Abschnittsfunkenstrecke. Deren elektrische Komponenten sind vorzugsweise innerhalb mehrerer übereinander befindlicher Isolatoren des Stossspannungsgenerators anzuordnen.

In einer weiteren Ausgestaltung des erfindungsgemäßen Stossspannungsgenerators ist der Überspannungsableiter mit dem Ausgang des Stossspannungsgenerators verbunden, vorzugsweise in deren jeweiligen oberen Bereich, um so eine für die Isolation günstige Spannungsaufteilung zu realisieren.

Der Platzbedarf für einen mit dem Stossspannungsgenerator zusammenwirkenden Überspannungsableiter ist dadurch vorteilhaft reduziert.

In einer weiteren Ausgestaltung des erfindungsgemäßen Stossspannungsgenerators sind wenigstens sowohl ein derartiger Spannungsteiler als auch ein derartiger Überspannungsableiter zumindest teilweise in diesen integriert.

In einer Ausführungsform des erfindungsgemäßen Stossspannungsgenerators sind dieser und ein äußerer Spannungsteiler mechanisch mittels einer längenverstellbaren und quer zu deren parallelen Längsachsen wirkenden Bewegungsvorrichtung miteinander verbunden. Es wären in diesem Fall beispielsweise ein Überspannungsableiter erfindungsgemäß in den Stossspannungsgenerator integriert und ein konventioneller Spannungsteiler im äußeren Bereich verschiebbar angeordnet oder umgekehrt.

Für den Fall, dass der Stossspannungsgenerator momentan nicht zu Prüfzwecken benutzt wird, lässt sich mittels der Bewegungsvorrichtung der Abstand des äußeren Spannungswandlers und der Stossspannungsgenerators platzsparend reduzieren. Für den Fall einer Prüfung ist der Abstand den isolationstechnischen Anforderungen entsprechend zu erhöhen.

Der Platzbedarf einer derartigen Anordnung wird zumindest für den Zeitraum, in welchem keine Prüfungen stattfinden, vorteilhaft reduziert. Eine derartige Anordnung ist auf diese Weise beispielsweise einfacher transportierbar.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: ein erstes Übersichtsbild mit einem Stossspannungsgenerator, einem Spannungsteiler und einem Prüfling,
- Fig. 2: die elektrischen Komponenten eines exemplarischen Stossspannungsgeneratormoduls sowie
- Fig. 3: ein exemplarisches Stossspannungsgeneratormodul

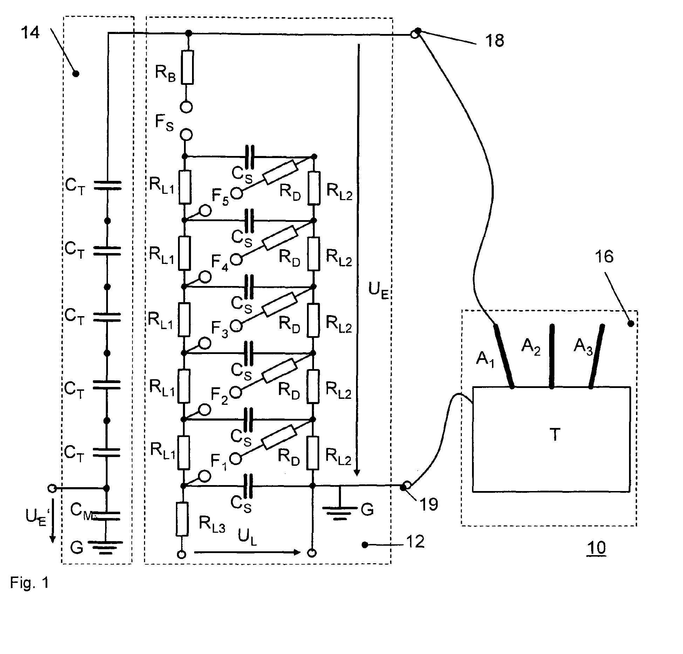

Fig. 1 zeigt ein erstes Übersichtsbild 10 mit einem Stossspannungsgenerator 12, einem Spannungsteiler 14 und einem Prüfling 16 in schematischer Darstellung.

Der Stossspannungsgenerator 12 ist mehrstufig aufgebaut und weist mehrere Stosskondensatoren C_{S}, Funkenstrecken F₁ bis F₅, mehrere Funkenstreckenwiderstände R_{D} sowie mehrere Ladewiderstände R_{L1} und R_{L2} auf. Diese Komponenten sind elektrisch derart verschaltet, dass bei Anliegen einer Ladespannung U_{L} ein paralleler Ladungsvorgang der Stosskapazitäten C_{S} über die Ladewiderstände R_{L1}, und R_{L3} erfolgt, welcher je nach Ausführung der Ladewiderstände mehrere Minuten dauert. Der Stossspannungsgenerator 12 ist an seiner untersten Stufe am Punkt G geerdet. Die stufenförmige Anordnung der elektrischen Komponenten C_{S}, F₁ bis F₅, R_{D}, R_{L1}, sowie R_{L2} in ihrem Schaltbild entspricht in etwa auch der stufenförmigen Anordnung dieser Komponenten im Stossspannungsgenerator.

Wenn die Stosskapazitäten C_{S} des Stossspannungsgenerators 12 geladen sind, werden zur Initiierung eines Stossspannungsimpulses die Stosskondensatoren elektrisch in Reihe geschaltet und entladen sich über den Prüfling 16, in der dargestellten Fig. einen Leistungstransformator in einer Prüfverschaltung. Hierzu wird vorzugsweise ein Funken an der triggerbaren Funkenstrecke F₁ erzeugt, welcher einen Durchschlag derselben zur Folge hat, wobei anschließend aufgrund der sich ändernden Spannungsverteilung alle weiteren Funkenstrecken F₂ bis F₅ von alleine zünden. Dieser Vorgang erfolgt im zeitlichen Bereich von einigen µs. Es baut sich demgemäß ein Spannungspotential an der elektrisch mit der obersten Stufe des Stossspannungsgenerators verbundenen Ausgangsfunkenstrecke F_{S} auf, bis zu deren elektrischem Durchschlag. Deren anderes Ende ist über einen Begrenzungswiderstand R_{B} und-einen Ausgang 18 des Stossspannungsgenerators 12 mit dem Prüfling 16, einem Leistungstransformator, verbunden. Der Leistungstransformator ist als dreiphasig gedacht dargestellt, wobei jeweils die drei Anschlüsse A₁, A₂ und A₃ der verschalteten Hochspannungswicklungen dargestellt sind. In dem in der Fig. dargestellten Testaufbau ist die erste Wicklung an einem Punkt 19 geerdet und über den Anschluss A1 mit dem Ausgang 18 des Stossspannungsgenerators verbunden.

Der Spannungsteiler 14 ist in der Fig. als kapazitiver Spannungsteiler dargestellt und ist als elektrische Reihenschaltung von mehreren Kondensatoren C_{T} und einem Kondensator C_{M} zwischen dem Ausgang 18 des Stossspannungsgenerators 12 und Erdpotential G realisiert. Die während eines Spannungsimpulses über dem Kondensator C_{M} abfallende Spannung U_{E}' ist entsprechend dem Teilerverhältnis näherungsweise proportional der an dem Ausgang 18 des Stossspannungsgenerators 12 und am Prüfling 16 anliegenden Spannung U_{E}.

Jeder Stosskondensator C_{S} bildet zusammen mit je einer benachbarten Komponente R_{L1}, R_{L2}, R_{D} und F₁, F₂, F₃, F₄ oder F₅ je ein Stossspannungsgeneratormodul, dem jeweils ein Kondensator C_{T} zugeordnet ist, welcher innerhalb eines hohlen Isolators eines jeweiligen Stossspannungsgeneratormoduls angeordnet ist. Die Reihenschaltung aller dargestellten Kondensatoren C_{T} ist als komplett innerhalb mehrerer übereinander angeordneter Isolatoren angeordnet anzusehen.

Die Spannung, welche im Stossspannungsgenerator 12 bei einem Spannungsimpuls auftritt, steigt aufgrund der üblichen Anordnung der elektrischen Komponenten C_{S}, R_{L1}, R_{L2}, R_{D} und F₁₋₅ mit steigender geometrischer Höhe. Dies ist bei Reihenschaltung von mehreren Innenkomponenten C_{T} innerhalb einer Säule aus Isolatoren ebenfalls gegeben, wenn die elektrische Reihenschaltung an ihrem unteren Ende durch entsprechende elektrische Verschaltung auf ein erdnahes Potential gezwungen ist und an ihrem oberen Ende mit dem Ausgang des Stossspannungsgenerators verbunden ist. Die Spannungsbelastung zwischen der jeweiligen Innenkomponente und den elektrischen Komponenten außerhalb des sie umgebenden Isolators ist somit in vorteilhafter Weise reduziert.

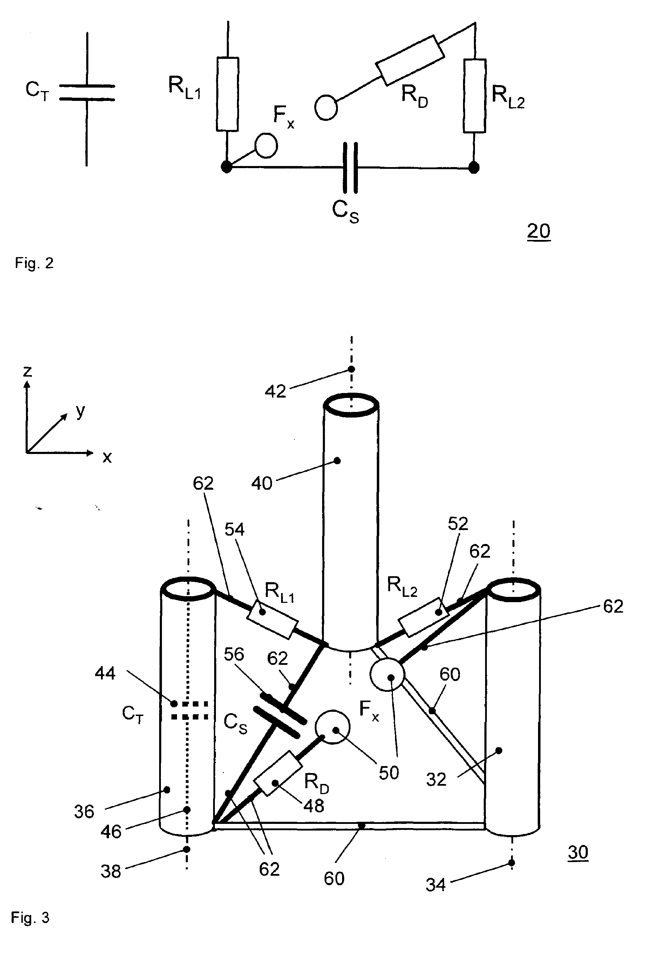

Fig. 2 zeigt die typischen elektrischen Komponenten eines exemplarischen Stossspannungsgeneratormoduls 20 mit fünf elektrischen Komponenten. Ein Stosskondensator C_{S} ist zusammen mit je einer benachbarten Widerstand R_{L1}, R_{L2}, R_{D} und einer Funkenstrecke F_{X} in einem Stossspannungsgeneratormodul angeordnet. Erfindungsgemäß ist auch ein Kondensator C_{T} Bestandteil des dargestellten Stossspannungsgeneratormoduls, welcher als im inneren Bereich eines zugehörigen Isolators angeordnet anzusehen ist.

Eine Aneinanderreihung eines derartigen Stossspannungsgeneratormoduls 20 ist auch im Stossspannungsgenerator 12 der Fig. 1 dargestellt, wobei dort die Reihenschaltung der Kondensatoren C_{T} einen wesentlichen Bestandteil des Spannungsteilers 14 bildet.

Fig. 3 zeigt ein exemplarisches Stossspannungsgeneratormodul 30 mit drei Isolatoren 32, 36, 40 in angedeuteter perspektivischer Darstellung. Drei hohlzylinderförmige Isolatoren 32, 36, 40 mit jeweils einem sich über deren gesamte Länge erstreckenden Hohlraum sind längs der parallel zueinander verlaufenden jeweiligen Mittelachsen 34, 38, 42 im gleichseitigen Dreieck angeordnet.

Im inneren Hohlraum des zweiten Isolators 36 ist ein Kondensator C_{T} mit dem Bezugszeichen 44 angeordnet, welcher bei Verschaltung mehrerer Stossspannungsgeneratormodule beispielsweise Teil eines Spannungsteilers ist. Durch die Anordnung innerhalb des Hohlraumes des zweiten Isolators 36 ist eine hinreichende Isolation zu den elektrischen Komponenten C_{S}, R_{L1}, R_{L2}, R_{D} und der Funkenstrecke F_{X} gegeben. Die genannten Komponenten entsprechen auch in der elektrischen Verschaltung denen in der Fig. 2 beschriebenen Komponenten und sind jeweils mit dem Bezugszeichen 56, 54, 52, 48 und 50 versehen.

Die Darstellung der elektrischen Komponenten 56, 54, 52, 48 und 50 erfolgt symbolisch durch ihr elektrisches Schaltzeichen, in einem realen Stossspannungsgeneratormodul sind diese in einem entsprechenden Gehäuse untergebracht. Eine elektrisch / mechanische Verbindung der elektrischen Komponenten 56, 54, 52, 48 und 50 ist mittels entsprechender Zuleitungen 62 vorgesehen, beispielsweise einem Metallstab, wobei jeweilige auf ein Ende eines Isolators 32, 36, 40 zulaufende Zuleitungen-vorzugsweise außerhalb des Isolators 32, 36, 40 elektrisch miteinander verbunden sind, beispielsweise mittels eines um ein jeweiliges Isolatorende angeordneten Metallringes.

Bei der elektrischen Verschaltung der Komponenten 56, 54, 52, 48 und 50 ist aus Isolationsgründen darauf zu achten, dass diese nicht im Innenraum eines Isolators. 32, 36, 40 erfolgt. Somit ist eine isolationstechnische Beeinträchtigung der notwendigen Isolation des Kondensators 44 beziehungsweise jeder anderen elektrischen Innenkomponente gegenüber den zuvor genannten außerhalb des Isolators angeordneten Komponenten vermieden. Der Kondensator 44 ist hierbei als Innenkomponente aufzufassen, ebenso wie beispielsweise ein innerhalb eines Isolators angeordneter Widerstand oder eine Funkenstrecke.

Bei der mechanischen Verbindung mehrerer Stossspannungsgeneratormodule 30 ist insbesondere an den Verbindungsstellen längs benachbarter Isolatoren 32, 36, 40 darauf zu achten, dass eine hinreichende Isolation von innerhalb der Isolatoren 32, 36, 40 angeordneter Innenkomponenten 44 und deren elektrischer Verbindung zueinander 46 gegenüber außerhalb der Isolatoren 32, 36, 40 angeordneter elektrischer Komponenten 56, 54, 52, 48 und 50 gegeben ist. Zur mechanischen Verstärkung des gezeigten Stossspannungsgeneratormoduls 30 sind Querstreben 60 angedeutet, welche vorzugsweise aus einem elektrisch isolierenden material bestehen.

Ein Stossspannungsgeneratormodul 30 hat eine Vielzahl weiterer Ausführungsformen, beispielsweise auch mit jeweils 2, 4 oder mehr Isolatoren 32, 36, 40. Ein Stossspannungsgeneratormodul 30 weist nicht zwangsläufig alle in Fig. 2 und Fig. 3 beschriebenen elektrischen Komponenten 56, 54, 52, 48 und 50 auf, wesentlicher Bestandteil ist vielmehr die Anordnung wenigstens einer elektrischen Innenkomponente im Hohlraum eines Isolators 32, 36, 40. Idealerweise ist der mechanische Aufbau eines Stossspannungsgeneratormoduls 30 derart, dass eine Vielzahl gleichartiger Module 30 übereinander anorden- und verschaltbar ist.

Isolatoren 32, 36, 40 mit einem hohlen Innenraum sind beispielsweise aus GFK, also glasfaserverstärkten Kunststoffen, oder auch aus Keramik zu fertigen.

### Bezugiszeichenliste

- 10: Übersichtsbild Stossspannungsgenerator, Spannungsteilers und Prüfling
- 12: Stossspannungsgenerator
- 14: Spannungsteiler
- 16: Prüfling
- 18: Ausgang des Stossspannungsgenerators
- 19: Erdungsausgang
- 20: Komponenten eines exemplarischen Stossspannungsgeneratormoduls
- 30: exemplarisches Stossspannungsgeneratormodul
- 32: erster Isolator
- 34: erste Mittelachse
- 36: zweiter Isolator
- 38: zweite Mittelachse
- 40: dritter Isolator
- 42: dritte Mittelachse
- 44: Spannungsteilerkondensator
- 46: Zuleitung zum Spannungsteilerkondensator
- 48: Funkenstreckenwiderstand
- 50: Funkenstrecke
- 52: zweiter Ladewiderstand
- 54: erster Ladewiderstand
- 56: Stosskondensator
- 60: Verbindungsstrebe
- 62: Zuleitung
- C_{T}: Erster Spannungsteilerkondensator
- C_{M}: Zweiter Spannungsteilerkondensator
- C_{S}: Stosskondensator
- R_{L1}: Erster Ladewiderstand
- R_{L2}: Zweiter Ladewiderstand
- R_{L3}: Dritter Ladewiderstand
- R_{D}: Funkenstreckenwiderstand
- R_{B}: Begrenzungswiderstand
- G: Erdpotential
- T: Leistungstransformator
- A1: Erster Anschluss des Leistungstransformators
- A2: Zweiter Anschluss des Leistungstransformators
- A3: Dritter Anschluss des Leistungstransformators
- U_{E}: Ausgangsspannung am Stossspannungsgenerator
- U_{E}': Ausgangsspannung am Spannungswandler
- U_{L}: Ladespannung
- F_{X}: Funkenstrecke
- F_{S}: Ausgangsfunkenstrecke
- F₁: erste Funkenstrecke
- F₂: zweite Funkenstrecke
- F₃: dritte Funkenstrecke
- F₄: vierte Funkenstrecke
- F₅: fünfte Funkenstrecke

## Patentansprüche

1. Stossspannungsgeneratormodul (30) mit wenigstens zwei rohrähnlichen Isolatoren (32, 34, 36), von denen wenigstens einer jeweils einen sich wenigstens über einen Teil dessen gesamter Länge erstreckenden inneren Hohlraum aufweist, wobei zwischen wenigstens zwei der Isolatoren (32, 34, 36) wenigstens eine elektrische Komponente (C_{S}, R_{L1}, R_{L2}, R_{D}, F_{X}) angeordnet und mechanisch mit diesen (32, 34, 36) verbunden ist, **dadurch gekennzeichnet, dass** wenigstens eine elektrische Innenkomponente (C_{T}) im Hohlraum des wenigstens einen der wenigstens zwei Isolatoren (32, 34, 36) angeordnet ist.

2. Stossspannungsgeneratormodul (30) nach Anspruch 1, **dadurch gekennzeichnet, dass** die wenigstens zwei Isolatoren (32, 34, 36) räumlich parallel zueinander angeordnet sind.

3. Stossspannungsgeneratormodul (30) nach Anspruch 1 oder 2, **dadurch gekennzeichnet, dass** die wenigstens eine elektrische Komponente (C_{S}, R_{L1}, R_{L2}, R_{D}, F_{X}) und die wenigstens eine elektrische Innenkomponente (C_{T}) jeweils ein Kondensator, eine Induktivität, ein Widerstand und/oder eine Funkenstrecke ist.

4. Stossspannungsgeneratormodul (30) nach Anspruch 1 bis 3, **dadurch gekennzeichnet, dass** wenigstens eine elektrische Komponente (C_{S}, R_{L1}, R_{L2}, R_{D}, F_{X}) und/oder eine elektrische Innenkomponente (C_{T}) jeweils eine Nennspannung von größer 20kV aufweist.

5. Stossspannungsgenerator (12), **dadurch gekennzeichnet, dass** wenigstens ein Stossspannungsgeneratormodul (30) nach einem der Ansprüche 1 bis 4 in diesem enthalten ist.

6. Stossspannungsgenerator (12) nach Anspruch 5, **dadurch gekennzeichnet, dass** die im Hohlraum des wenigstens einen Isolators (32, 34, 36) des wenigstens einen Stossspannungsgeneratormoduls (30) angeordnete elektrische Innenkomponente (C_{T}) mit wenigstens einer weiteren elektrischen Komponente elektrisch zusammenwirkt.

7. Stossspannungsgenerator (12) nach Anspruch 6, **dadurch gekennzeichnet, dass** die wenigstens eine weitere elektrische Komponente (C_{T}) eine elektrische Innenkomponente ist, welche im Hohlraum eines Isolators (32, 34, 36) eines weiteren Stossspannungsgeneratormoduls (30) des Stossspannungsgenerators (12) angeordnet ist.

8. Stossspannungsgenerator (12) nach Anspruch 6 oder 7, **dadurch gekennzeichnet, dass** die zusammenwirkenden Komponenten einen elektrischen Spannungsteiler (14) bilden.

9. Stossspannungsgenerator (12) nach Anspruch 8, **dadurch gekennzeichnet, dass** der Spannungsteiler (14) mit dem Ausgang (18) des Stossspannungsgenerators (12) verbunden ist.

10. Stossspannungsgenerator (12) nach Anspruch 6 oder 7, **dadurch gekennzeichnet, dass** die zusammenwirkenden Komponenten einen Überspannungsableiter bilden.

11. Stossspannungsgenerator (12) nach Anspruch 10, **dadurch gekennzeichnet, dass** der Überspannungsableiter und der Ausgang des Stossspannungsgenerators (12) miteinander verbunden ist.

12. Stossspannungsgenerator (12) nach Anspruch 8 bis 11, **dadurch gekennzeichnet, dass** ein Spannungsteiler (14) und ein Überspannungsableiter gebildet sind.

13. Stossspannungsgenerator (12) nach einem der Ansprüche 8 bis 12, **dadurch gekennzeichnet, dass** dieser und ein äußerer Spannungsteiler mechanisch mittels einer längenverstellbaren und quer zu deren parallelen Längsachsen wirkenden Bewegungsvorrichtung miteinander verbunden sind
